# EUROPEAN PATENT APPLICATION

(11) **EP 2 239 630 A2**
(43) Date of publication of application: **13.10.2010**
(21) Application number: 09706192.3
(22) Date of filing: 23.01.2009
(51) Int. Cl.: G03F 7/004

(54) **METHOD FOR SELECTIVE ADSORPTION OF NOBLE METAL CATALYST ONTO SURFACE OF POLYMER**

(30) Priority: 28.01.2008 KR 20080008626
(71) Applicant: Korea Institute of Industrial Technology, 35-3 Hongcheon-ri Ipjang-myun Seobuk-gu Cheonan-si Choongcheongnam-do 331-825 (KR)
(72) Inventor: LEE, Hong Kee, Goyang-si Gyeonggi-do 411-735 (KR)
(74) Representative: Barth, Stephan Manuel
(86) International application number: PCT/KR2009/000384
(87) International publication number: WO 2009/096691

(57) **Abstract**

The present invention relates to a method for the selective adsorption of a noble metal catalyst onto a surface of a polymer. More particularly, the method of the present invention includes a first step of masking with a photomask, the surface of a polymer adsorbed with a photosensitive metal ion, and radiating light onto the surface of the polymer such that the photosensitive metal ion on the unmasked surface is oxidized, and a second step of permitting the photosensitive metal ion which is not oxidized in the first step to react to a noble metal catalyst such that the noble metal catalyst is adsorbed onto the surface of the polymer.

## Description

### [Technical Field]

The present invention relates to a method of selectively adsorbing a precious metal catalyst on polymer surface. A polymer film including a metal layer having a predetermined form can be manufactured using the method.

### [Background Art]

Currently, as a technology for forming a metal circuit pattern on a polymer material such as polyimide (PI), polyethylene terephthalate (PET) or the like, which is used as a dielectric for flexible circuit boards or packages, a method of forming a metal circuit pattern by forming a predetermined circuit pattern on the surface of a polymer clad or deposited with thin copper foil using photoresist processing and then etching the copper foil is widely used.

Such a conventional technology used to form a metal circuit pattern is problematic in that it is complicated, it includes long unit processes, it needs high-priced equipment, and it causes environmental pollution due to the formation of a corrosive etching solution. Further, this conventional technology used to form a metal circuit pattern is problematic in that cheap raw materials and expensive precise equipment are additionally required to realize a micro-circuit pattern or it is very difficult to realize the micro-circuit pattern.

Meanwhile, methods of forming a metal layer on a polymer material are conducted by a laminating or casting process. In the laminating or casting process, a polymer material is surface-modified by plasma ions, and then a conductive metal junction layer is formed on the surface of the surface-modified polymer material using a dry surface treatment technology such as sputtering, metal deposition or the like, and then a metal coating layer is formed on the surface of the conductive metal junction layer using an electroplating technology or a copper film is directly bonded to the surface of the polymer material.

Recently, a process of metalizing a polymer film using wet surface treatment has been developed. In this process, a metal circuit is also formed by forming a metal layer on a polymer material and then etching the metal layer with copper using photoresist processing. However, this process is also problematic in that it is not easy to form a relatively uniform metal layer, and in that high production expenses are incurred.

Thus, the present inventors found that the above problems can be solved by using a method of adsorbing a precious metal catalyst on a polymer film during wet surface treatment. Based on this finding, the present invention was completed.

### [Disclosure]

### [Technical Problem]

An object of the present invention is to provide a method of selectively adsorbing a precious metal catalyst on polymer surface.

Another object of the present invention is to provide a polymer film including a metal layer formed by wet-plating the polymer on which the precious metal catalyst is selectively adsorbed using the method.

### [Advantageous Effects]

The polymer adsorbed with the precious metal catalyst, prepared using the method of the present invention, is advantageous in that various shapes of metal pattern layers can be simply and easily formed on the surface thereof, and a metal circuit layer made of copper, nickel or the like adheres closely to the surface thereof, and thus it can be easily used in automobiles, electronics, communications and semiconductors requiring micro-circuit boards. Further, when the polymer is prepared using the method of the present invention, there is an advantage in that the manufacturing cost thereof becomes low compared to conventional technologies, and expensive equipment is not required.

### [Brief Description of Drawing]

FIG. 1 is a process view showing a method of selectively adsorbing a precious metal on the surface of a polymer adsorbed with photosensitive metal ions according to an embodiment of the present invention;
FIG. 2 is a graph showing the changes in the chemical structure of tin (Sn) ions by a photochemical reaction using X-ray photoelectron spectroscopy (XPS) after UV irradiation according to the present invention; and

FIG. 3 is a graph showing the results of the adsorption of a precious metal catalyst (for example, Pd°) using X-ray photoelectron spectroscopy (XPS) after UV irradiation according to the present invention.

### [Best Mode]

In an aspect, the present invention is directed to a method of selectively adsorbing a precious metal catalyst on the surface of a polymer. More concretely, the present invention is directed to a method of selectively adsorbing a precious metal catalyst on polymer surface, including the steps of: 1) masking the surface of a polymer adsorbed with photosensitive metal ions with a photomask and then irradiating the surface of the polymer with a light source to oxidize the photosensitive metal ions which are on the non-masked surface of the polymer; and 2) reacting the photosensitive metal ions not oxidized in step 1) with a precious metal catalyst to adsorb the precious metal catalyst on the surface of the polymer.

The polymer used in the present invention includes polyimide, polyethylene terephthalate (PET) and aramid film, and is used to fabricate a flexible copper clad laminate (FCCL) which is an intermediate material used in a flexible printed circuit board (FPCB), to form an electronic circuit pattern or to prevent electromagnetic interference (EMI). It is preferred that the polymer used in the present invention be a polymer adsorbed with photosensitive metal ions.

The photosensitive metal ions are metal ions causing a photochemical reaction using a light source, and, concretely, include titanium (Ti) ions, molybdenum (Mo) ions, tungsten (W) ions and tin (Sn) ions. In the embodiment of the present invention, a polymer whose surface is adsorbed with tin ions is used as the polymer. The method of adsorbing the photosensitive metal ions on the surface of the polymer may be conducted using the methods well known in the related field, preferably, the method disclosed in Korea Patent Application No. 2007-0003316, filed by the present inventors. Concretely, the method of adsorbing the photosensitive metal ions on the surface of the polymer may include the steps of: immersing the surface of the polymer into an alkali metal compound solution (for example, alkali metal hydroxide, alkali earth metal hydroxide or the like) or spraying the alkali metal compound solution onto the surface of the polymer to hydrophilize the surface of the polymer; providing functional groups onto the surface of the polymer to modify the surface of the polymer; and immersing the modified surface of the polymer into a solution containing photosensitive metal ions or spraying the solution onto the modified surface of the polymer.

The precious metal catalyst used in the present invention is silver (Ag), palladium (Pd), platinum (Pt), gold (Au) or the like.

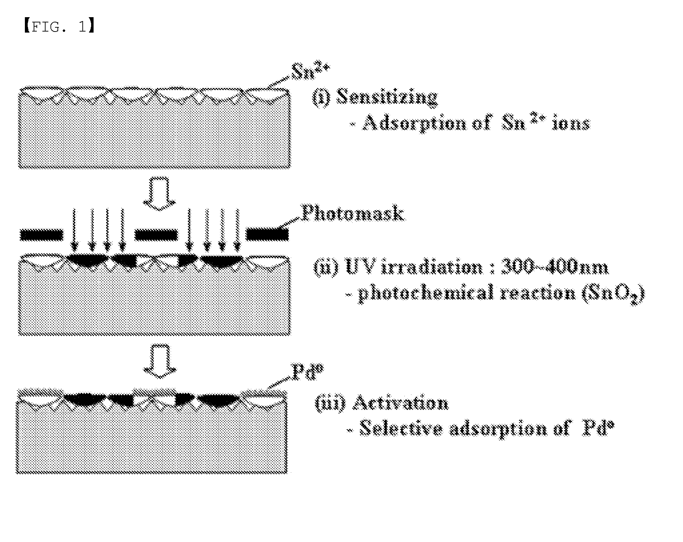

FIG. 1 shows a method of selectively adsorbing a precious metal on the surface of a polymer adsorbed with photosensitive metal ions according to an embodiment of the present invention. Hereinafter, the method of selectively adsorbing a precious metal on the surface of a polymer will be described in detailed steps with reference to FIG. 1.

Fist, the surface of a polymer adsorbed with photosensitive metal ions is masked with a photomask, and then the surface of the polymer is irradiated with a light source to oxidize the photosensitive metal ions which are on the non-masked surface of the polymer.

Concretely, the specific portion of the surface of the polymer adsorbed with photosensitive metal ions, that is, the portion of the surface of the polymer to be adsorbed with photosensitive metal ions, is masked with a photomask to block a light source, and the portion which is not blocked by the light source is irradiated with the light source to oxidize the photosensitive metal ions. The light source may be ultraviolet (UV) and have a wavelength of 200 ∼ 450 nm, preferably, 300 ∼ 420 nm. When the wavelength of the light source is below 200 nm, there is a problem in that manufacturing costs increase because the light source is expensive. Further, when the wavelength thereof is above 450 nm, there is a problem in that the oxidation of the photosensitive metal compound, that is, a photochemical reaction, is very slowly conducted or does not proceed at all. Further, the irradiation intensity of the light source is 10 - 30 mW/cm²_{.}

Second, the photosensitive metal ions which are not oxidized in the first step are reacted with a precious metal catalyst to adsorb the precious metal catalyst on the surface of the polymer.

Concretely, a solution containing the precious metal catalyst is brought into contact with the surface of the polymer, and thus the photosensitive metal ions which are not oxidized by blocking the light source using the photomask in the first step are reacted with the precious metal catalyst to adsorb the precious metal catalyst on the surface of the polymer. For convenience, this step is called an activation process. The activation process may be performed at a temperature of 20 - 50°C, preferably, 20 - 30°C for 20 seconds - 5 minutes, preferably, 30 seconds - 2 minutes such that the precious metal catalyst is sufficiently adsorbed on the surface of the polymer.

When the polymer adsorbed with a precious metal catalyst, prepared using the above method, is used, a metal circuit pattern can be easily formed on the surface of the polymer by wet surface treatment such as electroless plating or the like. The wet surface treatment such as electroless plating or the like may be conducted using a method known in the related field. The polymer including the metal circuit pattern formed in this way can be easily used in automobiles, electronics, communications and semiconductors requiring micro-circuit boards because copper, nickel or the like adheres thinly and closely to the surface thereof.

### [Mode for Invention]

Hereinafter, the present invention will be described in more detail with reference to the following Examples. However, the scope of the present invention is not limited thereto.

### Example 1

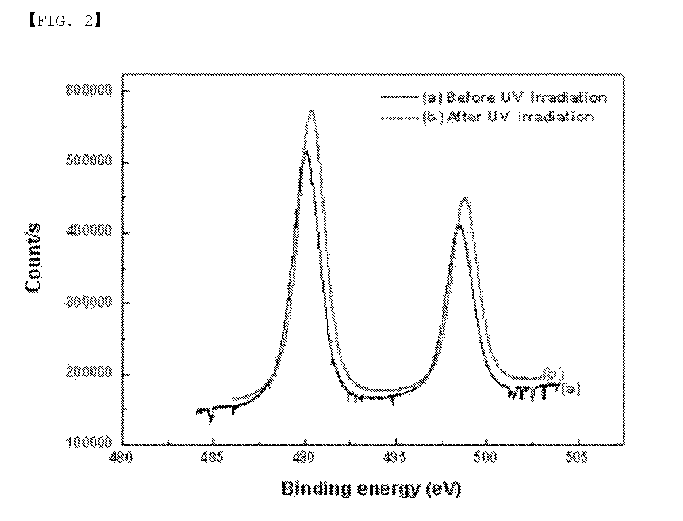

Polyimide (PI) or polyethylene terephthalate (PET), as a polymer, was immersed in a photosensitive metal ion-containing solution having the composition given in Table 1 below for 4 - 8 minutes, and then tin ions (Sn²⁺), which are photosensitive metal ions, were adsorbed on the surface of the polymer. Subsequently, a photomask was disposed on the surface of the polymer adsorbed with the tin ions (Sn²⁺), and the surface thereof was irradiated with ultraviolet (UV) light having a wavelength of 365 nm. The tin ions (Sn²⁺) which are on the UV-irradiated surface of the polymer were oxidized into tin ions (Sn4⁺) by a photochemical reaction. The changes of the tin ions depending on whether the photochemical reaction was conducted or not were analyzed using X-ray photoelectron spectroscopy (XPS), and the results thereof are shown in FIG. 2.

**[Table 1]**

| SnCl₂ | HCl |
|---|---|
| 0.3∼0.6mol/l | 0.08mol/l |
| Temperature: 18∼25°C, treatment time: 4∼8 minutes | |

### Example 2

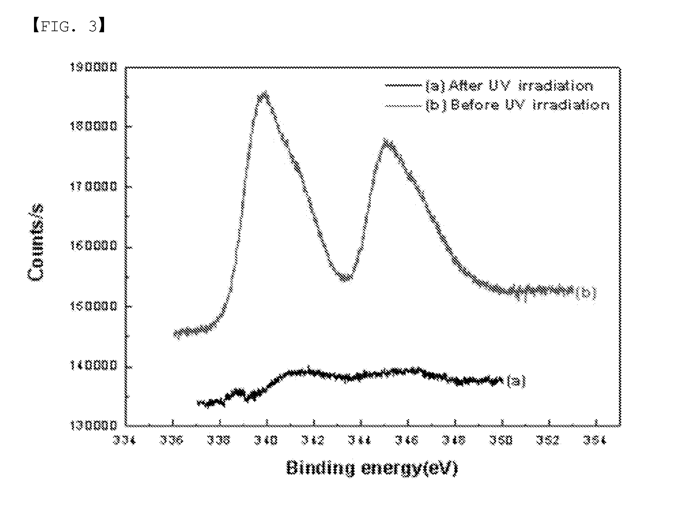

The surface of the polymer of Example 1 was immersed in a precious metal catalyst solution having the composition given in Table 2. Palladium ions (Pd²⁺) were reduced to palladium (Pd°) to be adsorbed on the surface of the polymer. The changes of the palladium ions depending on whether the photochemical reaction was conducted or not were analyzed using X-ray photoelectron spectroscopy (XPS), and the results thereof are shown in FIG. 3.

**[Table 2]**

| PdCl₂ | HCl |
|---|---|
| 0.03mol/l | 0.02mol/l |
| Temperature: 18∼25°C, treatment time: 30 seconds | |

### [Industrial Applicability]

The polymer adsorbed with a precious metal catalyst, prepared using the method of the present invention, is advantageous in that various shapes of metal pattern layers can be simply and easily formed on the surface thereof, and a metal circuit layer made of copper, nickel or the like adheres closely to the surface thereof, and thus it can be easily used in automobiles, electronics, communications and semiconductors requiring micro-circuit boards.

## Claims

1. A method of selectively adsorbing a precious metal catalyst on a polymer surface, comprising the steps of:
1) masking a surface of a polymer adsorbed with a photosensitive metal ions with a photomask and then irradiating the surface of the polymer with a light source to oxidize photosensitive metal ions which are on the non-masked surface of the polymer; and
2) reacting the photosensitive metal ion not oxidized in step 1) with a precious metal catalyst to adsorb the precious metal catalyst on the surface of the polymer.

2. The method according to claim 1, wherein the polymer is any one selected from the group consisting of polyimide (PI), polyethylene terephthalate (PET), and aramid film.

3. The method according to claim 1, wherein the photosensitive ion is any one selected from the group consisting of titanium (Ti) ion, molybdenum (Mo) ion, tungsten (W) ion, and tin (Sn) ion.

4. The method according to claim 1, wherein the light source is an ultraviolet (UV) light source.

5. The method according to claim 4, wherein the ultraviolet (UV) light source has a wavelength of 200 ∼ 450 nm.

6. The method according to claim 1, wherein the precious metal catalyst is any one selected from the group consisting of silver (Ag), palladium (Pd), platinum (Pt), and gold (Au).

7. The method according to claim 1, wherein the step 2) is performed at a temperature of 20 - 50°C for 20 seconds - 5 minutes.
